# FASCICULE DE BREVET EUROPEEN

(11) **EP 1 732 374 B1**
(45) Date de publication et mention de la délivrance du brevet: **30.07.2008**
(21) Numéro de dépôt: 06290894.2
(22) Date de dépôt: 01.06.2006
(51) Int. Cl.: H05K 7/14

(54) **Dispositif à cartes électroniques comprenant un coffre et un tiroir à cartes électroniques prévu pour être inséré dans le coffre**
Leiterplatteneinrichtung mit einem Gehäuse und Einschub für Leiterplatten zum Einsetzen in das Gehäuse
Circuit board device comprising a receptacle and drawer for circuit boards to be inserted into the receptacle

(30) Priorité: 07.06.2005 FR 0505785
(43) Date de publication de la demande: 13.12.2006
(73) Titulaire: Alstom Transport SA, 92300 Levallois-Perret (FR)
(72) Inventeur: Ruque, Christian, 69960 Corbas (FR)
(74) Mandataire: Blot, Philippe Robert Emile

(56) Documents cités:
- FR-A- 2 346 941
- FR-A- 2 743 977
- US-B1- 6 496 364
- PATENT ABSTRACTS OF JAPAN vol. 2003, no. 08, 6 août 2003 (2003-08-06) -& JP 2003 101263 A (RICOH CO LTD), 4 avril 2003 (2003-04-04)

## Description

La présente invention concerne un dispositif à cartes électroniques, du type comprenant :
- un coffre ;
- un tiroir insérable de façon amovible dans le coffre ;
- au moins une carte électronique insérable de façon amovible dans le tiroir ;
- au moins un connecteur électrique de carte fixé sur le tiroir, la ou chaque carte comprenant un connecteur électrique de carte adapté pour s'embrocher avec le ou chaque connecteur de carte du tiroir lorsque la ou chaque carte est insérée dans le tiroir ; et
- au moins un connecteur électrique de sortie fixé sur le coffre, la ou chaque carte comprenant un connecteur électrique de sortie adapté pour s'embrocher avec le ou chaque connecteur de sortie du coffre, lorsque la ou chaque carte ayant été préalablement insérée dans le tiroir, le tiroir est inséré dans le coffre.

Le document FR -A- 2 743 977 décrit un dispositif du type précité, dans lequel les connecteurs de carte du tiroir sont fixés sur une carte solidaire du tiroir, dénommée carte mère, du côté du tiroir opposé aux connecteurs de sortie du coffre, et les cartes amovibles, dénommées cartes filles, sont munies de connecteurs de carte et de connecteurs de sortie disposés sur des bords opposés de la ou chaque carte fille.

Ce dispositif facilite la connexion des connecteurs de sortie des cartes filles et du coffre lors de l'insertion du tiroir.

Néanmoins, avec un tel dispositif, pour retirer une carte fille, par exemple en vue de son remplacement, il est nécessaire de retirer le tiroir du coffre, et de retirer la carte fille du tiroir. Ceci complique les opérations de maintenance ou de remplacement des cartes filles.

Un but de l'invention et de proposer un dispositif à cartes électroniques facilitant l'insertion et l'extraction d'une carte ou du tiroir contenant une ou plusieurs cartes.

A cet effet, l'invention propose un dispositif à cartes électroniques du type précité, caractérisé en ce que :
- le tiroir comprend une ouverture permettant l'insertion de la ou chaque carte dans le tiroir selon une direction et un sens d'insertion de la ou chaque carte dans le tiroir lorsque le tiroir a préalablement été inséré dans le coffre;
- la direction d'insertion de la ou chaque carte dans le tiroir inséré dans le coffre est sensiblement identique à la direction d'insertion du tiroir dans le coffre; et
- les connecteurs de sortie et les connecteurs de carte sont disposés de façon à s'embrocher selon la direction et le sens de la ou chaque carte dans le tiroir inséré dans le coffre, de sorte que l'insertion de la ou chaque carte dans le tiroir, lorsque le tiroir a préalablement été inséré dans le coffre, provoque l'embrochement respectif des connecteurs de sortie et des connecteurs de carte.

Selon d'autres modes de réalisation, le dispositif à cartes électroniques comprend une ou plusieurs des caractéristiques suivantes, prise(s) isolément ou selon toutes les combinaisons techniquement possibles :
- le tiroir comprend une ouverture située en regard du ou de chaque connecteur de sortie du coffre lorsque le tiroir est reçu dans le coffre, de façon à permettre l'embrochage du connecteur de sortie de la ou chaque carte reçue dans le tiroir avec le ou chaque connecteur de sortie du coffre à travers l'ouverture,
- l'ouverture permettant l'embrochage des connecteurs de sortie est ménagée dans une paroi du tiroir située à l'avant du tiroir en considérant la direction et le sens d'insertion de la ou chaque carte dans le tiroir,
- le ou chaque connecteur de sortie du coffre est disposé le long d'une paroi du coffre située à l'avant du coffre en considérant la direction et le sens d'insertion du tiroir dans le coffre,
- le ou chaque connecteur de carte du tiroir est disposé sur une paroi du tiroir située à l'avant du tiroir en considérant la direction et le sens d'insertion de la ou chaque carte dans le tiroir,
- le connecteur de sortie de la ou chaque carte est disposé le long d'un bord situé à l'avant de la ou chaque carte en considérant la direction et le sens d'insertion de la ou chaque carte dans le tiroir,
- le connecteur de carte de la ou chaque carte est disposé le long d'un bord situé à l'avant de la ou chaque carte en considérant la direction et le sens d'insertion de la ou chaque carte dans le tiroir,
- le dispositif est dépourvu de connecteur fixé sur le tiroir et destiné à s'embrocher avec un connecteur fixé sur le coffre,
- l'ouverture du tiroir permettant l'insertion de la ou chaque carte est située en regard d'une ouverture du coffre permettant l'insertion du tiroir, lorsque le tiroir est inséré dans le coffre.

L'invention et ses avantages seront mieux compris à la lecture de la description qui va suivre, donnée uniquement à titre d'exemple, et faite en se référant aux dessins annexés sur lesquels :
- la figure 1 est une vue schématique latérale d'un dispositif à cartes électroniques conforme à l'invention; et
- les figures 2 et 3 sont des vues analogues à celle de la figure 1, illustrant respectivement l'extraction ou l'introduction d'une carte électronique, et l'extraction ou l'introduction d'un tiroir contenant les cartes électroniques.

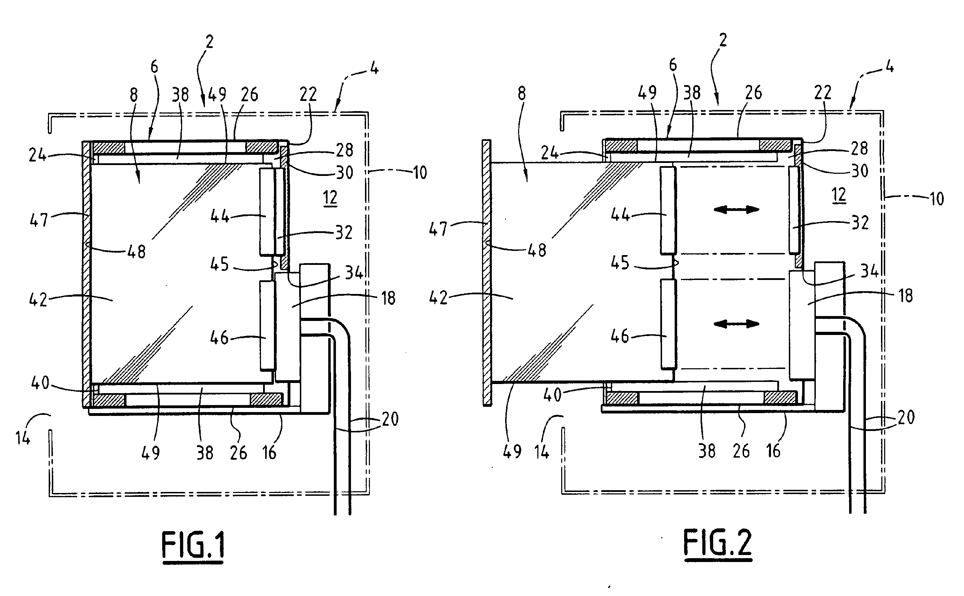

Tel que représenté sur la figure 1, le dispositif à cartes électroniques 2 comprend un coffre 4, un tiroir 6 monté de façon amovible dans le coffre 4, et plusieurs cartes électroniques 8, dénommées cartes filles, montées de façon amovible dans le tiroir 6, une seule d'entre elles étant visible sur la figure 1.

Le coffre 4 est par exemple un coffre d'une armoire électronique, comprenant une pluralité de coffres, d'une locomotive, d'une machine outil, et plus généralement d'une machine électrique.

Le coffre 4 comprend une enceinte 10, schématisée par un contour en traits doubles mixtes, délimitant un logement 12 et présentant une ouverture arrière 14.

L'ouverture 14 permet l'insertion du tiroir 6 dans le coffre 4 suivant une direction et un sens déterminé, de la gauche vers la droite sur la figure 1. De même, l'ouverture 14 permet l'extraction du tiroir 6 hors du coffre 4, dans le sens opposé, c'est-à-dire de la droite vers la gauche sur la figure 1.

Dans la suite de la description, les termes « avant » et « arrière » s' entendent en considérant la direction et le sens d'insertion du tiroir 6 dans le coffre 4.

Le coffre 4 comprend, dans le logement 12, un support 16 et des connecteurs électriques de sortie 18, un seul étant visible, disposés à l'avant du support 16, au fond du coffre 4. Chaque connecteur 18 est relié à une installation électrique distante par l'intermédiaire de faisceaux électriques 20.

Le tiroir 6 comprend une paroi avant de fond 22, une paroi arrière 24, et des parois latérales 26 s'étendant entre les parois 22 et 24. Les parois 22, 24 et 26 délimitent un logement 28 de réception des cartes 8.

Le tiroir 6 comprend une carte électroniques 30, dénommée carte mère, et fixée sur une zone supérieure de la paroi 22.

La carte mère 30 comprend des connecteurs électriques de cartes 32, seul un connecteur 32 étant visible sur la figure 1.

La paroi 22 est munie dans une zone inférieure d'une ouverture avant 34, située en regard des connecteurs 18.

Pour le montage de chaque carte 8, le tiroir 6 comprend une glissière supérieure 38 et une glissière inférieure 38 fixées sur les parois 26, et s'étendant de l'arrière vers l'avant du tiroir 6.

La paroi 24 est munie d'une ouverture arrière 40 permettant l'insertion des cartes 8 dans le tiroir 6 suivant une direction et un sens d'insertion identiques à la direction et au sens d'insertion du tiroir 6 dans le coffre 4. Les ouvertures 40 et 14 sont en regard.

Chaque carte 8 comprend une plaque de support 42 portant des composants électriques et/ou électroniques. Les cartes 8 sont sensiblement identiques et diffèrent entre elles par les composants qu'elles portent et les schémas de connexion entre ces composants.

Chaque carte 8 comprend un connecteur de carte 44 et un connecteur de sortie 46 fixés sur un même bord avant 45 de la plaque 42.

Le connecteur 44 est embroché avec un connecteur 32 correspondant, et le connecteur 46 est embroché avec un connecteur 18 correspondant à travers l'ouverture 34.

Les connecteur 44 et 32, et les connecteurs 46 et 18 s'embrochent et se débrochent suivant la direction d'insertion de chaque carte 8 dans le tiroir 6.

Chaque carte 8 comprend une façade 47 fixée sur un bord arrière 48 de la plaque 42, et a des bords latéraux 49 engagés dans les glissières 38.

Le tiroir 6 et le coffre 4 sont dépourvus de connecteurs complémentaires fixés sur le tiroir 6 et le coffre 4 et s'embrochant mutuellement lors de l'insertion du tiroir 6 dans le coffre 4.

Comme illustré sur la figure 2, il est possible d'extraire individuellement chaque carte 8 hors du tiroir 6. Pour ce faire, la carte 8 est extraite vers l'arrière à travers les ouvertures 14 et 40. Ce faisant, les connecteurs 44 et 32 et les connecteurs 46 et 18 se débrochent automatiquement et simultanément.

De façon analogue, il est possible d'insérer chaque carte 8 dans le tiroir 6, préalablement reçu dans le coffre 4, par les ouvertures 14 et 40. L'insertion de la carte 8 dans le tiroir 6 provoque simultanément et automatiquement l'embrochage des connecteurs de carte 44 et 32, d'une part, et des connecteurs de sortie 46 et 18, d'autre part.

Il est donc possible d'effectuer l'insertion ou l'extraction de chaque carte 8 sans extraire le tiroir 6 du coffre 4.

Ceci est rendu possible notamment par le fait que les connecteurs 18 et 32 s'embrochent et se débrochent suivant la direction d'insertion de chaque carte 8 dans le tiroir 6, et est facilité par la disposition des connecteurs 44, 46 de chaque carte 8 sur le bord 45, et des connecteurs 18 et 32 correspondants au fond du tiroir 6 lorsque celui-ci est reçu dans le coffre 4.

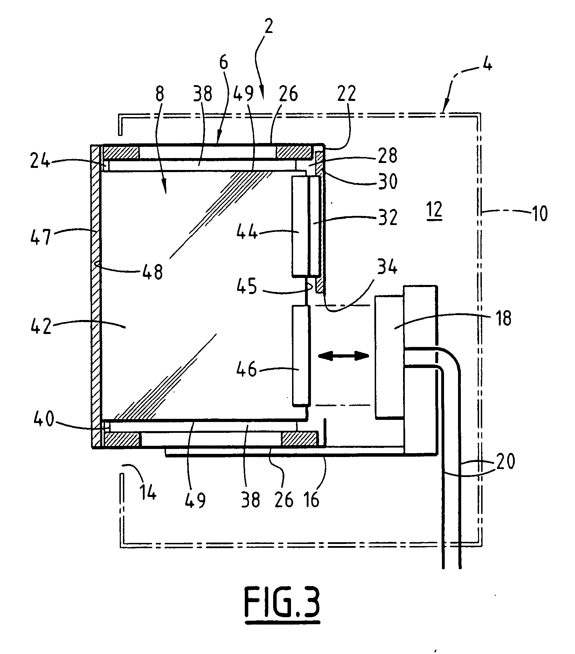

Comme illustré sur la figure 3, il est possible d'extraire le tiroir 6 contenant les cartes 8 hors du coffre 4, par l'ouverture 14.

Ce faisant, les cartes 8 restent dans le tiroir 6 et les connecteurs 32 et 44 restent embrochés, tandis que les connecteurs 46 et 18 sont automatiquement débrochés.

De façon analogue, il est possible d'insérer le tiroir 6 contenant les cartes 8 dans le coffre 6 par l'ouverture 14. Dans ce cas, le tiroir 6 est enfoncé jusqu'à ce que les connecteurs 46 et 18 s'embrochent à travers l'ouverture 34.

Ceci est rendu possible notamment par le fait que les connecteurs 18 et 32 s'embrochent et se débrochent suivant la direction d'insertion du tiroir 6 dans le coffre 4.

Le dispositif 2 permet donc d'extraire sélectivement une carte 8 ou le tiroir 6 par des opérations simples.

Le dispositif 2 est économique dans la mesure où le nombre de connecteurs électriques est réduit, et est peu sensible aux parasites électromagnétiques dans la mesure où les cartes 8 sont connectées au connecteur 18 directement, sans utiliser de fils électriques.

Le dispositif 2 est en outre compact étant donné que les connecteurs 18 se connectent directement aux connecteurs 46 à travers l'ouverture 34. Les connecteurs 32 et 18 sont protégés étant donné qu'ils sont situés au fond du tiroir 6 et du coffre 4, et ils ne risquent pas d'être endommagés.

Par ailleurs, la fabrication et la maintenance sont simplifiées, et la fiabilité est améliorée du fait de l'usage limité de fils électriques.

Il est possible de prévoir un couvercle de fermeture de l'ouverture 40 du tiroir 6, et un couvercle de fermeture de l'ouverture 14 du coffre 4.

## Revendications

1. Dispositif à cartes électroniques, du type comprenant :
- un coffre (4) ;
- un tiroir (6) insérable de façon amovible dans le coffre (4) ;
- au moins une carte électronique (8) insérable de façon amovible dans le tiroir (6) ;
- au moins un connecteur électrique de carte (32) fixé sur le tiroir (6), la ou chaque carte (8) comprenant un connecteur électrique de carte (44) adapté pour s'embrocher avec le ou chaque connecteur de carte (32) du tiroir (6) lorsque la ou chaque carte (8) est insérée dans le tiroir (6) ; et
- au moins un connecteur de sortie (18) fixé sur le coffre (4), la ou chaque carte (8) comprenant un connecteur électrique de sortie (46) adapté pour s'embrocher avec le ou chaque connecteur de sortie (18) du coffre (4), lorsque la ou chaque carte (8) ayant été préalablement insérée dans le tiroir (6), le tiroir (6) est inséré dans le coffre (4) ;
**caractérisé en ce que**
- le tiroir (6) comprend une ouverture (40) permettant l'insertion de la ou chaque carte (8) dans le tiroir (6) selon une direction et un sens d'insertion de la ou chaque carte (8) dans le tiroir (6) lorsque le tiroir (6) a préalablement été inséré dans le coffre (4) ;
- la direction d'insertion de la ou chaque carte (8) dans le tiroir (6) inséré dans le coffre (4) est sensiblement identique à la direction d'insertion du tiroir (6) dans le coffre (4) ; et
- les connecteurs de sortie (18, 46) et les connecteurs de carte (32, 44) sont disposés de façon à s'embrocher selon la direction et le sens de la ou chaque carte (8) dans le tiroir (6) inséré dans le coffre (4), de sorte que l'insertion de la ou chaque carte (8) dans le tiroir (6), lorsque le tiroir (6) a préalablement été inséré dans le coffre (4), provoque l'embrochement respectif des connecteurs de sortie (18, 46) et des connecteurs de carte (32, 44).

2. Dispositif selon la revendication 1, **caractérisé en ce que** le tiroir (6) comprend une ouverture (34) située en regard du ou de chaque connecteur de sortie (18) du coffre (4) lorsque le tiroir (6) est reçu dans le coffre (4), de façon à permettre l'embrochage du connecteur de sortie (46) de la ou chaque carte (8) reçue dans le tiroir (6) avec le ou chaque connecteur de sortie (18) du coffre (4) à travers l'ouverture (34).

3. Dispositif selon la revendication 2, **caractérisé en ce que** l'ouverture (34) permettant l'embrochage des connecteurs de sortie (46, 18) est ménagée dans une paroi du tiroir (6) située à l'avant du tiroir (6) en considérant la direction et le sens d'insertion de la ou chaque carte (8) dans le tiroir (6).

4. Dispositif selon l'une quelconque des revendications précédentes, **caractérisé en ce que** le ou chaque connecteur de sortie (18) du coffre (4) est disposé le long d'une paroi du coffre (4) située à l'avant du coffre (4) en considérant la direction et le sens d'insertion du tiroir (6) dans le coffre (4).

5. Dispositif selon l'une quelconque des revendications précédentes, **caractérisé en ce que** le ou chaque connecteur de carte (32) du tiroir (6) est disposé sur une paroi du tiroir (6) située à l'avant du tiroir (6) en considérant la direction et le sens d'insertion de la ou chaque carte (8) dans le tiroir (6).

6. Dispositif selon l'une quelconque des revendications précédentes, **caractérisé en ce que** le connecteur de sortie (46) de la ou chaque carte (8) est disposé le long d'un bord (45) situé à l'avant de la ou chaque carte (8) en considérant la direction et le sens d'insertion de la ou chaque carte (8) dans le tiroir (6).

7. Dispositif selon l'une quelconque des revendications précédentes, **caractérisé en ce que** le connecteur de carte (44) de la ou chaque carte (8) est disposé le long d'un bord (45) situé à l'avant de la ou chaque carte (8) en considérant la direction et le sens d'insertion de la ou chaque carte (8) dans le tiroir (6).

8. Dispositif selon l'une quelconque des revendications précédentes, **caractérisé en ce qu'**il est dépourvu de connecteur fixé sur le tiroir (6) et destiné à s'embrocher avec un connecteur fixé sur le coffre (4).

9. Dispositif selon l'une quelconque des revendications précédentes, **caractérisé en ce que** l'ouverture (40) du tiroir (6) permettant l'insertion de la ou chaque carte (8) est située en regard d'une ouverture (14) du coffre (4) permettant l'insertion du tiroir (6), lorsque le tiroir (6) est inséré dans le coffre (4).

## Claims

1. Circuit board device, of the type comprising:
- a receptacle (4);
- a drawer (6) that can be removably inserted in the receptacle (4);
- at least one circuit board (8) that can be removably inserted in the drawer (6);
- at least one circuit board connector (32) fixed to the drawer (6), the or each board (8) comprising a circuit board connector (44) adapted to plug into the or each board connector (32) of the drawer (6) when the or each board (8) is inserted in the drawer (6); and
- at least one output connector (18) fixed to the receptacle (4), the or each board (8) comprising an electrical output connector (46) adapted to plug into the or each output connector (18) of the receptacle (4) when the drawer (6) is inserted in the receptacle (4), the or each board (8) having previously been inserted in the drawer (6);
**characterised in that**
- the drawer (6) comprises an opening (40) allowing the insertion of the or each board (8) in the drawer in one direction and orientation of insertion of the or each board (8) in the drawer (6) when the drawer (6) has previously been inserted in the receptacle (4);
- the direction of insertion of the or each board (8) in the drawer (6) inserted in the receptacle (4) is substantially identical to the direction of insertion of the drawer (6) in the receptacle (4); and
- the output connectors (18, 46) and the board connectors (32, 44) are arranged so as to engage in the direction and orientation of insertion of the or each board (8) in the drawer (6) inserted in the receptacle (4), so that the insertion of the or each card (8) in the drawer (6), when the drawer (6) has previously been inserted in the receptacle (4), causes the respective engagement of the output connectors (18, 46) and the board connectors (32, 44).

2. Device according to claim 1, **characterised in that** the drawer (6) comprises an opening (34) located opposite the or each output connector (18) of the receptacle (4) when the drawer (6) is received in the receptacle (4), so as to allow the engagement of the output connector (46) of the or each board (8) received in the drawer (6) with the or each output connector (18) of the receptacle (4) through the opening (34).

3. Device according to claim 2, **characterised in that** the opening (34) that allows the engagement of the output connectors (46, 18) is formed in a wall of the drawer (6) situated at the front of the drawer (6) with respect to the direction and orientation of insertion of the or each board (8) in the drawer (6).

4. Device according to any one of the preceding claims, **characterised in that** the or each output connector (18) of the receptacle (4) is arranged along a wall of the receptacle (4) located at the front of the receptacle (4) with respect to the direction and orientation of insertion of the drawer (6) into the receptacle (4).

5. Device according to any one of the preceding claims, **characterised in that** the or each board connector (32) of the drawer (6) is arranged on a wall of the drawer (6) situated at the front of the drawer (6) with respect to the direction and orientation of insertion of the or each board (8) in the drawer (6).

6. Device according to any one of the preceding claims, **characterised in that** the output connector (46) of the or each board (8) is arranged along an edge (45) situated at the front of the or each board (8) with respect to the direction and orientation of insertion of the or each board (8) in the drawer (6).

7. Device according to any one of the preceding claims, **characterised in that** the board connector (44) of the or each board (8) is arranged along an edge (45) situated at the front of the or each board (8) with respect to the direction and orientation of insertion of the or each board (8) in the drawer (6).

8. Device according to any one of the preceding claims, **characterised in that** it lacks a connector fixed to the drawer (6) and intended to plug into a connector fixed to the receptacle (4).

9. Device according to any one of the preceding claims, **characterised in that** the opening (40) in the drawer (6) that allows the insertion of the or each board (8) is located opposite an opening (14) in the receptacle (4) that allows the drawer (6) to be inserted, when the drawer (6) is inserted in the receptacle (4).

## Patentansprüche

1. Elektronikkartenvorrichtung einer Art, welche aufweist:
- einen Schrank (4);
- einen Einschub (6), der lösbar in den Schrank (4) einsetzbar ist;
- wenigstens eine Elektronikkarte (8), die in lösbarer Weise in den Einschub (6) einsetzbar ist;
- wenigstens einen am Einschub (6) befestigten elektrischen Kartenverbinder (32), wobei die oder jede Karte (8) einen elektrischen Kartenverbinder (44) aufweist, der so eingerichtet ist, dass er mit dem oder jedem Kartenverbinder (32) des Einschubs (6) zusammensteckbar ist, wenn die oder jede Karte (8) in den Einschub (6) eingesetzt wird; und
- wenigstens einen am Schrank (4) befestigten Ausgangsverbinder (18), wobei die oder jede Karte (8) einen elektrischen Ausgangsverbinder (46) aufweist, der so eingerichtet ist, dass er mit dem oder jedem Ausgangsverbinder (18) des Schranks (4) zusammensteckbar ist, wenn bei vorher in den Einschub (6) eingesetzter Karte (8) oder eingesetzten Karten (8) der Einschub (6) in den Schrank (4) eingesetzt wird;
**dadurch gekennzeichnet, dass**
- der Einschub (6) eine Öffnung (40) aufweist, die das Einführen der oder jeder Karte (8) in den Einschub (6) gemäß einer Einsetzrichtung und einem Einsetzsinn der oder jeder Karte (8) in den Einschub (6) gestattet, wenn der Einschub (6) vorher in den Schrank (4) eingesetzt worden ist;
- die Einsetzrichtung der oder jeder Karte (8) in den in den Schrank (4) eingesetzten Einschub (6) im Wesentlichen mit der Einsetzrichtung des Einschubs (6) in den Schrank (4) identisch ist; und
- die Ausgangsverbinder (18, 46) und die Kartenverbinder (32, 44) so angeordnet sind, dass sie sich in der Richtung und dem Sinne der oder jeder Karte (8) in den in den Schrank (4) eingesetzten Einschub (6) einstecken, so dass das Einsetzen der oder jeder Karte (8) in den Einschub (6), wenn der Einschub (6) vorher in den Schrank (4) eingesetzt worden ist, dass Zusammenstecken der Ausgangsverbinder (18, 46) und der Kartenverbinder (32, 44) bewirkt.

2. Vorrichtung nach Anspruch 1, **dadurch gekennzeichnet, dass** der Einschub (6) eine Öffnung (34) aufweist, die dem oder jedem Ausgangsverbinder (18) des Schranks (4) zugekehrt ist, wenn der Einschub (6) im Schrank (4) aufgenommen ist, derart, dass Zusammenstecken des Ausgangsverbinders (46) der oder jeder im Einschub (6) aufgenommenen Karte (8) mit dem oder jedem Ausgangsverbinder (18) des Schranks (4) durch die Öffnung (34) ermöglicht ist.

3. Vorrichtung nach Anspruch 2, **dadurch gekennzeichnet, dass** die Öffnung (34), die das Einstecken der Ausgangsverbinder (46, 18) gestattet, in einer Wand des Einschubs (6) ausgebildet ist, die bei Betrachtung der Einsetzrichtung und des Einsetzsinnes der oder jeder Karte (8) in den Einschub (6) vor dem Einschub (6) liegt.

4. Vorrichtung nach einem der vorstehenden Ansprüche, **dadurch gekennzeichnet, dass** der oder jede Ausgangsverbinder (18) des Schranks (4) längs einer Wand des Schranks (4) angeordnet ist, die bei Betrachtung der Einsetzrichtung und des Einsetzsinnes des Einschubs (6) in den Schrank (4) vor dem Schrank (4) liegt.

5. Vorrichtung nach einem der vorstehenden Ansprüche, **dadurch gekennzeichnet, dass** der oder jeder Kartenverbinder (32) des Einschubs (6) an einer Wand des Einschubs (6) angeordnet ist, die bei Betrachtung der Einsetzrichtung und des Einsetzsinnes der oder jeder Karte (8) in den Einschub (6) vor dem Einschub (6) liegt.

6. Vorrichtung nach einem der vorstehenden Ansprüche, **dadurch gekennzeichnet, dass** der Ausgangsverbinder (46) der oder jeder Karte (8) längs eines Randes (45) angeordnet ist, der bei Betrachtung der Einsetzrichtung und des Einsetzsinnes der oder jeder Karte (8) in den Einschub (6) vor der oder jeder Karte (8) liegt.

7. Vorrichtung nach einem der vorstehenden Ansprüche, **dadurch gekennzeichnet, dass** der Kartenverbinder (44) der oder jeder Karte (8) längs eines Randes (45) angeordnet ist, der bei Betrachtung der Einsetzrichtung und des Einsetzsinnes der oder jeder Karte (8) in den Einschub (6) vor der oder jeder Karte (8) liegt.

8. Vorrichtung nach einem der vorstehenden Ansprüche, **dadurch gekennzeichnet, dass** sie von einem am Einschub (6) befestigten und zum Zusammenstecken mit dem am Schrank (4) befestigten Verbinder bestimmten Verbinder frei ist.

9. Vorrichtung nach einem der vorstehenden Ansprüche, **dadurch gekennzeichnet, dass** die Öffnung (40) des Einschubs (6), der das Einsetzen der oder jeder Karte (8) gestattet, vor einer Öffnung (14) des Schranks (4) zugekehrt angeordnet ist, die das Einsetzen des Einschubs (6) gestattet, wenn der Einschub (6) in den Schrank (4) eingesetzt wird.
